(19) Europäisches Patentamt
European Patent Office
Office européen des brevets

(11) **EP 4 063 340 A1**

(12) **EUROPEAN PATENT APPLICATION**
published in accordance with Art. 153(4) EPC

(43) Date of publication:
**28.09.2022 Bulletin 2022/39**

(21) Application number: **20889063.2**

(22) Date of filing: **20.11.2020**

(51) International Patent Classification (IPC):
**C04B 37/02** (2006.01)     **H05K 7/20** (2006.01)

(52) Cooperative Patent Classification (CPC):
**C04B 37/02; H05K 7/20**

(86) International application number:
**PCT/JP2020/043413**

(87) International publication number:
**WO 2021/100860 (27.05.2021 Gazette 2021/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.11.2019   JP 2019211422**
**19.11.2020   JP 2020192559**

(71) Applicant: **Mitsubishi Materials Corporation**
**Tokyo 100-8117 (JP)**

(72) Inventor: **TERASAKI Nobuyuki**
**Saitama-shi, Saitama 330-8508 (JP)**

(74) Representative: **Hoffmann Eitle**
**Patent- und Rechtsanwälte PartmbB**
**Arabellastraße 30**
**81925 München (DE)**

(54) **CERAMIC/COPPER/GRAPHENE ASSEMBLY AND METHOD FOR MANUFACTURING SAME, AND CERAMIC/COPPER/GRAPHENE JOINING STRUCTURE**

(57)     In a ceramic/copper/graphene assembly, a ceramic member, a copper member formed of copper or a copper alloy, and a graphene-containing carbonaceous member containing a graphene aggregate are joined. At a joining interface between the copper member and the graphene-containing carbonaceous member, an active metal carbide layer containing a carbide of one or more kinds of active metals selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

FIG. 3

## Description

[Technical Field]

The present invention relates to a ceramic/copper/graphene assembly having a structure in which a ceramic member, a copper member formed of copper or a copper alloy, and a graphene-containing carbonaceous member containing a graphene aggregate are joined and a method for manufacturing the same, and a ceramic/copper/graphene joining structure.

Priority is claimed on Japanese Patent Applications No. 2019-211422 filed November 22, 2019, and No. 2020-192559 filed on November 19, 2020, the content of which is incorporated herein by reference.

[Background Art]

A graphene-containing carbonaceous member containing a graphene aggregate is particularly suitable for a member constituting a heat dissipation member, a heat conductive member, and the like because it has excellent thermal conductivity.

For example, an insulating layer formed of ceramic is formed on a surface of the graphene-containing carbonaceous member containing a graphene aggregate as described above, and it is thus possible to use the graphene-containing carbonaceous member as an insulation substrate.

For example, Patent Document 1 here discloses an anisotropic heat conduction element which has a structure in which a graphene sheet is laminated along a first direction, and an intermediate member (copper plate) joined to an end surface of the structure in a second direction intersecting the first direction, and in which the intermediate member is pressure-joined to the end surface via an insert material containing at least titanium.

[Citation List]

[Patent Document]

[Patent Document 1]

Japanese Unexamined Patent Application, First Publication No. 2012-238733

[Summary of Invention]

[Technical Problem]

Meanwhile, thermal cycles in the insulation substrate described above may be loaded in a use environment. In particular, recently, the thermal cycles may be used in a harsh environment such as an engine room, and the thermal cycles under a severe condition of a large temperature difference may be loaded.

Here, in Patent Document 1 described above, the intermediate formed of copper and the graphene structure are joined via the insert material containing titanium. However, the intermediate formed of copper and the graphene structure cannot be firmly joined according to the joining conditions, and thus peeling may occur during loading of the thermal cycles with the severe condition.

Moreover, when a copper/graphene assembly in Patent Document 1 is installed in a predetermined device as a heat dissipation member, a current flows into a joined part through the intermediate because the copper intermediate having conductivity comes into contact with the device, the joining between the copper intermediate and the graphene structure cannot thus be maintained.

The present invention has been made in view of the above-mentioned circumstances, and an object thereof is to provide a ceramic/copper/graphene assembly having excellent reliability on thermal cycles, in which a copper member formed of copper or a copper alloy and a graphene-containing carbonaceous member containing a graphene aggregate are firmly joined, thereby preventing a current from flowing into the joined part without peeling occurred during loading of the thermal cycles, and a method for manufacturing the same.

[Solution to Problem]

In order to solve the problem and achieve the object, a ceramic/copper/graphene assembly according to the present invention is a ceramic/copper/graphene assembly having a structure in which a ceramic member, a copper member formed of copper or a copper alloy, and a graphene-containing carbonaceous member containing a graphene aggregate are joined, in which at a joining interface between the copper member and the graphene-containing carbonaceous member, an active metal carbide layer containing a carbide of one or more kinds of active metals selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

In the ceramic/copper/graphene assembly with this configuration, at the joining interface between the copper member and the graphene-containing carbonaceous member, the active metal carbide layer is formed on a joining surface of the graphene-containing carbonaceous member, and the Mg solid solution layer having Mg dissolved in the matrix phase of Cu is formed on a joining surface side of the copper member. As a result, Mg in the Mg solid solution layer sufficiently reacts with the active metal in the active metal carbide layer, and the copper member is firmly joined to a graphene-containing carbonaceous material via (or through) the active metal carbide layer, such that it is possible to prevent cracks and peeling from occurring at the joining interface during loading of thermal cycles. Moreover, the ceramic/copper/graphene assembly with this configuration contains copper as a constituent material thereof, and thus has a function of efficiently dissipating heat as a heat spreader in a transition period.

Further, in the ceramic/copper/graphene assembly with this configuration, the copper member having conductivity is covered with the ceramic member, such that it is possible to prevent a current from flowing into the joined part through the copper member, and to maintain joining between the copper member and the graphene-containing carbonaceous member, when the assembly comes into contact with a predetermined device.

Therefore, the ceramic/copper/graphene assembly with this configuration can maintain stable heat dissipation characteristics and can realize high reliability while preventing occurrence of peeling at the joining interface accompanied by the thermal cycles.

Here, in the ceramic/copper/graphene assembly according to the present invention, preferably, a Cu-Mg intermetallic compound phase formed of an intermetallic compound containing Cu and Mg is present in the Mg solid solution layer.

In this case, the Cu-Mg intermetallic compound phase is distributed on a joining surface side with the active metal carbide layer, which is greatly involved in the joining, such that it is possible to enhance the strength of the joining with the active metal carbide layer.

A ratio B/A is preferably 0.3 or less, where A is the area of a region in the Mg solid solution layer within a distance of 50 $\mu$m from a boundary between the active metal carbonized layer and the Mg solid solution layer toward the copper member, and B is the area of the Cu-Mg intermetallic compound phase.

Further, in the ceramic/copper/graphene assembly according to the present invention, preferably, a second intermetallic compound phase formed of an intermetallic compound containing Cu and the active metal is present in the Mg solid solution layer.

In this case, the second intermetallic compound phase is distributed on a joining surface side with the active metal carbide layer, which is greatly involved in the joining, such that it is possible to enhance the strength of the joining with the active metal carbide layer.

Further, in the ceramic/copper/graphene assembly according to the present invention, the ceramic member is composed of oxygen-containing ceramic, and a magnesium oxide layer may be formed on the ceramic member side at the joining interface between the ceramic member and the copper member.

In this case, it is possible to strengthen the joining between the oxygen-containing ceramic member and the copper member due to the formation of the magnesium oxide layer, and it is possible to prevent cracks and peeling from occurring at the joining interface during loading of the thermal cycles.

Further, in the ceramic/copper/graphene assembly according to the present invention, the ceramic member is composed of nitrogen-containing ceramic, and an active metal nitride layer containing a nitride of one or more kinds of active metals selected from Ti, Zr, Nb, and Hf may be formed on the ceramic member side at the joining interface between the ceramic member and the copper member.

In this case, it is possible to strengthen the joining between the nitride-containing ceramic member and the copper member due to the formation of the active metal nitride layer containing a nitride of one or more kinds of active metals selected from Ti, Zr, Nb, and Hf, and it is possible to prevent cracks and peeling from occurring at the joining interface during loading of the thermal cycles.

Moreover, in the ceramic/copper/graphene assembly according to the present invention, the graphene-containing carbonaceous member contains flat graphite particles and the graphene aggregate formed by deposition of a single layer or multiple layers of graphene; and the flat graphite particles preferably has a structure in which the flat graphite particles are laminated with the graphene aggregate as a binder so that basal surfaces of the flat graphite particles overlap with one another, and the basal surfaces of the flat graphite particles are oriented in one direction.

In this case, thermal conduction properties of the graphene-containing carbonaceous member can be further improved.

A method for manufacturing a ceramic/copper/graphene assembly according to the present invention is a method for manufacturing the ceramic/copper/graphene assembly described above, and includes a copper/graphene joining step of joining the copper member and the graphene-containing carbonaceous member; and a copper/ceramic joining step of joining the copper member and the ceramic member, in which the copper/graphene joining step includes an active metal and Mg disposing step of disposing one or more kinds of active metals selected from Ti, Zr, Nb, and Hf and Mg between the copper member and the graphene-containing carbonaceous member, a laminating step of laminating the copper member and the graphene-containing carbonaceous member via (or through) the active metal and Mg, and a joining step of joining the copper member and the graphene-containing carbonaceous member by laminating the copper member and the graphene-containing carbonaceous member via (or through) the active metal and Mg and performing a heat-treat in a vacuum atmosphere while pressurizing the copper member and the graphene-containing carbonaceous member in a laminating direction, and in the active metal and Mg disposing step, the amount of the active metal is set to 0.4 $\mu$mol/cm$^2$ or more, and the amount of Mg is set to 14 $\mu$mol/cm$^2$ or more.

According to the method for manufacturing a ceramic/copper/graphene assembly with this configuration, the amount of the active metal is set to 0.4 $\mu$mol/cm$^2$ or more and the amount of Mg is set to 14 $\mu$mol/cm$^2$ or more in the active metal and Mg disposing step, such that it is possible to sufficiently obtain a liquid phase required for an interfacial reaction. Therefore, the copper member and the graphene-containing carbonaceous material can be reliably joined.

Here, in the method for manufacturing a ceramic/copper/graphene assembly according to the present invention, preferably, the pressurizing load in the joining step is set to be within a range of 0.049 MPa or more and 1.96 MPa or less, and the heating temperature in the joining step is set to be within a range of 700°C or higher and 950°C or lower.

In this case, in the joining step, the pressurizing load is set to be within a range of 0.049 MPa or more and 1.96 MPa or less, and the heating temperature is set to be within range of 700°C or higher and 950°C or less, such that it is possible to hold a liquid phase required for an interfacial reaction, and promote a uniform interfacial reaction.

Further, in the method for manufacturing a ceramic/copper/graphene assembly according to the present invention, preferably, in the copper/ceramic joining step, one or more kinds of active metals selected from Ti, Zr, Nb, and Hf and Mg are disposed between the copper member and the ceramic member, and are heat-treated in a vacuum atmosphere while pressurizing in the laminating direction, together with the copper member and the graphene-containing carbonaceous member which are laminated via (or through) the active metal and Mg.

In this case, the joining between the copper member and the ceramic member is strengthened using one or more kinds of active metals selected from Ti, Zr, Nb, and Hf and Mg as a joining material, such that it is possible to prevent cracks and peeling from occurring at the joining interface during loading of the thermal cycles.

Further, in the method for manufacturing a ceramic/copper/graphene assembly according to the present invention, preferably, in the copper/ceramic joining step, Mg is disposed between the copper member and the ceramic member, and is heat-treated and joined in a vacuum atmosphere while pressurizing in the laminating direction, together with the copper member and the graphene-containing carbonaceous member which are laminated via (or through) Mg.

In this case, the joining between the copper member and the ceramic member is strengthened using Mg as a joining material, such that it is possible to prevent cracks and peeling from occurring at the joining interface during loading of the thermal cycles.

A ceramic/copper/graphene joining structure according to the present invention is a ceramic/copper/graphene joining structure having a structure in which a ceramic member, a copper member formed of copper or a copper alloy, and a graphene-containing carbonaceous member containing a graphene aggregate are joined, in which at a joining interface between the copper member and the graphene-containing carbonaceous member, an active metal carbide layer containing a carbide of one or more kinds of active metals selected from Ti, Zr, Nb, and Hf is formed on a side of the graphene-containing carbonaceous member, and a Mg solid solution layer having Mg dissolved in a matrix phase of Cu is formed between the active metal carbide layer and the copper member.

In the ceramic/copper/graphene joining structure with this configuration, at the joining interface between the copper member and the graphene-containing carbonaceous member, the active metal carbide layer is formed on a joining surface of the graphene-containing carbonaceous member, and the Mg solid solution layer having Mg dissolved in the matrix phase of Cu is formed on a joining surface side of the copper member. As a result, Mg in the Mg solid solution layer sufficiently reacts with the active metal in the active metal carbide layer, and the copper member is firmly joined to a graphene-containing carbonaceous material via (or through) the active metal carbide layer, such that it is possible to prevent cracks and peeling from occurring at the joining interface during loading of thermal cycles. Moreover, the ceramic/copper/graphene joining structure with this configuration contains copper as a constituent material thereof, and thus has a function of efficiently dissipating heat as a heat spreader in a transition period.

Further, in the ceramic/copper/graphene joining structure with the configuration, the copper member having conductivity is covered with the ceramic member, such that it is possible to prevent a current from flowing into the joined part through the copper member, and to maintain joining between the copper member and the graphene-containing carbonaceous member, when the structure comes into contact with a predetermined device.

Therefore, the ceramic/copper/graphene joining structure with the configuration can maintain stable heat dissipation characteristics and can realize high reliability while preventing occurrence of peeling at the joining interface accompanied by the thermal cycles.

[Advantageous Effects of Invention]

According to the present invention, it is possible to provide a copper/graphene assembly having excellent reliability on thermal cycles, in which a copper member formed of copper or a copper alloy and a graphene-containing carbonaceous member containing a graphene aggregate are firmly joined, thereby preventing a current from flowing into the joined part without peeling occurred during loading of the thermal cycles, and a method for manufacturing the same.

[Brief Description of Drawings]

Fig. 1 is a schematic explanatory view of a power module using a ceramic/copper/graphene assembly (insulation substrate) according to an embodiment of the present invention.

Fig. 2 is a schematic explanatory view of the ceramic/copper/graphene assembly (insulation substrate) according to an embodiment of the present invention.

Fig. 3 is an enlarged schematic view of a joining interface between a copper member and a graphene-containing carbonaceous member and a joining interface between a copper member and a ceramic member in the ceramic/copper/graphene assembly (insulation substrate) according to the embodiment of the present invention.

Fig. 4 is a flowchart showing an example of a method for manufacturing a ceramic/copper/graphene assembly (insulation substrate) according to the embodiment of the present invention.

[Description of Embodiments]

Hereinafter, embodiments of the present invention will be described with reference to the accompanying drawings. Each of embodiments shown below is for specific explanation for the sake of better understanding of the concept of the present invention, and the present invention is not limited unless otherwise specified. In the drawings used in the following description, in order to make the characteristics of the present invention easy to understand, the main parts may be shown in an enlarged manner, and dimensional ratios and the like of the respective constituent elements are not necessarily the same as the actual ratios and the like.

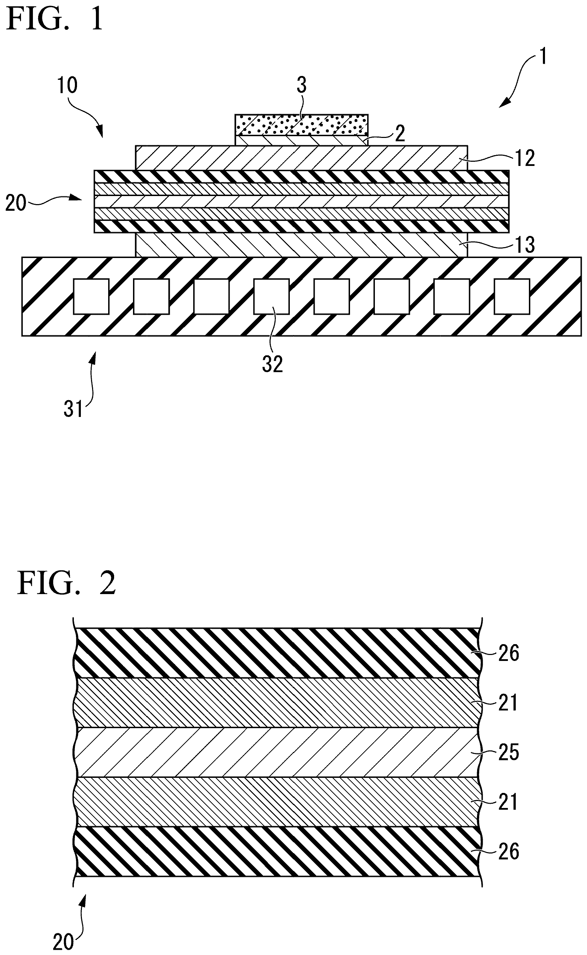

First, a ceramic/copper/graphene assembly (ceramic/copper/graphene joining structure) according to an embodiment of the present invention will be described with reference to Figs. 1 to 4.

The ceramic/copper/graphene assembly in the present embodiment is an insulation substrate 20 having a structure in which a ceramic member, a copper member formed of copper and a copper alloy, and a graphene-containing carbonaceous member containing a graphene aggregate are joined.

First, a power module using the ceramic/copper/graphene assembly (insulation substrate 20) according to the present embodiment will be described.

A power module 1 shown in Fig. 1 includes an insulating circuit substrate 10, a semiconductor element 3 joined to one surface side (upper side in Fig. 1) of the insulating circuit substrate 10 via a solder layer 2, and a heat sink 31 disposed on the other surface side (lower side in Fig. 1) of the insulating circuit substrate 10.

The insulating circuit substrate 10 includes an insulating layer (insulation substrate 20), a circuit layer 12 disposed on one surface (upper surface in Fig. 1) of the insulating layer, and a metal layer 13 disposed on the other surface (lower surface in Fig. 1) of the insulating layer.

The insulating layer prevents electrical connection between the circuit layer 12 and the metal layer 13, and is composed of the insulation substrate 20 according to the present embodiment.

The circuit layer 12 is formed by joining a metal plate having excellent conductivity to one surface of the insulating layer (insulation substrate 20). In the present embodiment, a copper plate formed of copper or a copper alloy, specifically, a rolled plate of oxygen-free copper is used as the metal plate constituting the circuit layer 12. The circuit layer 12 has a circuit pattern formed thereon, and one surface (upper surface in Fig. 1) thereof is a mounting surface on which the semiconductor element 3 is mounted.

In addition, the thickness of the metal plate (copper plate) serving as the circuit layer 12 is set to be within a range of 0.1 mm or more and 1.0 mm or less, and in the present embodiment, the thickness is set to 0.6 mm.

A method for joining the metal plate (copper plate) serving as the circuit layer 12 and the insulation substrate 20 is not particularly limited, and the metal plate (copper plate) serving as the circuit layer 12 and the insulation substrate 20 can be joined using an active metal brazing material or the like.

The metal layer 13 is formed by joining a metal plate having excellent thermal conductivity to the other surface of the insulating layer (insulation substrate 20). In the present embodiment, a copper plate formed of copper or a copper alloy, specifically, a rolled plate of oxygen-free copper is used as the metal plate constituting the metal layer 13.

In addition, the thickness of the metal plate (copper plate) serving as the metal layer 13 is set to be within a range of 0.1 mm or more and 1.0 mm or less, and in the present embodiment, the thickness is set to 0.6 mm.

A method for joining the metal plate (copper plate) serving as the metal layer 13 and the insulation substrate 20 is not particularly limited, and the metal plate (copper plate) serving as the metal layer 13 and the insulation substrate 20 can be joined using an active metal brazing material or the like.

The heat sink 31 is provided to cool the above-described insulating circuit substrate 10, and has a structure in which a plurality of flowing paths 32 for flowing a cooling medium (for example, cooling water) are provided.

The heat sink 31 is preferably formed of a material having good thermal conductivity, such as aluminum or an aluminum alloy and copper or a copper alloy, and in the present embodiment, the heat sink 31 may be formed of 2N aluminum having a purity of 99 mass% or more.

In the present embodiment, the metal layer 13 of the insulating circuit substrate 10 and the heat sink 31 are joined by a solid-phase diffusion joining method.

The semiconductor element 3 is formed using, for example, a semiconductor material such as Si or SiC. The semiconductor element 3 is mounted on the circuit layer 12 via, for example, a solder layer 2 formed of a solder material based on Sn-Ag, Sn-In, or Sn-Ag-Cu.

As shown in Fig. 2, the insulation substrate 20 according to the present embodiment constituting the insulating layer has a structure in which a ceramic plate 26 composed of the ceramic member, a copper plate 21 composed of a copper member formed of copper or a copper alloy, and a carbon plate 25 composed of a graphene-containing carbonaceous member containing a graphene aggregate are laminated. The copper plates 21 are each joined to both main surfaces of the carbon plate 25.

Here, as the insulation substrate 20, the ceramic plate 26, the copper plate 21, the carbon plate 25, the copper plate 21, and the ceramic plate 26 are laminated in this order. However, an outermost layer (end portion) of the insulation substrate in a laminating direction is the ceramic plate 26, and the number of layers laminated is not limited as long as and the order of the ceramic plate 26, the copper plate 21, and the carbon plate 25 is maintained.

The graphene-containing carbonaceous member constituting the carbon plate 25 contains a graphene aggregate obtained by deposition of a single layer or multiple layers of graphene, and flat graphite particles, and preferably has a structure in which the flat graphite particles are laminated with the graphene aggregate as a binder so that the basal surfaces of the flat graphite particles overlap with one another. The basal surfaces of the flat graphite particles preferably have a structure in which they are oriented in one direction.

The flat graphite particles have a basal surface on which a carbon hexagonal net surface appears and an edge surface on which an end portion of the carbon hexagonal net surface appears. As the flat graphite particles, scaly graphite, scale-like graphite, earthy graphite, flaky graphite, kish graphite, pyrolytic graphite, highly-oriented pyrolytic graphite, and the like can be used.

Here, an average particle size of the graphite particles viewed from the basal surface is preferably within a range of 10 $\mu$m or more and 1,000 $\mu$m or less, and more preferably within a range of 50 $\mu$m or more and 800 $\mu$m or less. The average particle size of the graphite particles is set to be within the above range, thereby improving thermal conductivity.

Furthermore, the thickness of the graphite particles is preferably within a range of 1 $\mu$m or more and 50 $\mu$m or less, and more preferably within a range of 1 $\mu$m or more and 20 $\mu$m or less. The thickness of the graphite particles is set to be within the above range, thereby properly adjusting orientation of the graphite particles.

In addition, by setting the thickness of the graphite particles within a range of 1/1,000 to 1/2 of the particle size viewed from the basal surface, excellent thermal conductivity is obtained and the orientation of the graphite particles is properly adjusted.

The graphene aggregate is a deposit of a single layer or multiple layers of graphene, and the number of multiple layers of graphene laminated is, for example, 100 layers or less, and preferably 50 layers or less. The graphene aggregate can be produced by, for example, dripping a graphene dispersion obtained by dispersing a single layer or multiple layers of graphene in a solvent containing a lower alcohol or water onto filter paper, and depositing the graphene while separating the solvent therefrom.

Here, an average particle size of the graphene aggregate is preferably within a range of 1 $\mu$m or more and 1,000 $\mu$m or less. The average particle size of the graphene aggregate is set to be within the above range, thereby improving thermal conductivity.

Furthermore, the thickness of the graphene aggregate is preferably within a range of 0.05 $\mu$m or more and less than 50 $\mu$m. The thickness of the graphene aggregate is set to be within the above range, thereby securing the strength of the carbonaceous member.

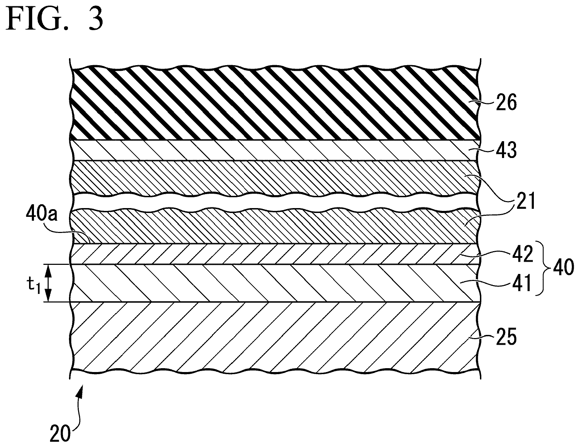

Here, Fig. 3 shows an enlarged schematic diagram of a joining interface between the copper plate 21 composed of a copper member formed of copper or a copper alloy and the carbon plate 25 formed of the graphene-containing carbonaceous member, and a joining interface between the copper plate 21 and the ceramic plate 26. As shown in Fig. 3, an active metal carbide layer 41 containing one or two kinds of active metal carbides is formed on a joining surface with the carbon plate 25 between the copper plate 21 formed of the copper member and the carbon plate 25 formed of the graphene-containing carbonaceous member (joining interface 40).

Further, the copper plate 21 contains single metals such as Mg and Cu, intermetallic compounds (IMCs) such as Cu-Mg and Cu-Ti, and the like, and particularly, a Mg solid solution layer 42 having Mg dissolved in a matrix phase of Cu is formed between the copper plate 21 and the active metal carbide layer 41 at the joining interface 40. In the Mg solid solution layer 42, a Cu-Mg intermetallic compound phase formed of an intermetallic compound containing Cu and Mg may be present, or a second intermetallic compound phase formed of an intermetallic compound containing Cu and an active metal may be present.

The Cu-Mg intermetallic compound phase is composed of a $Cu_2Mg$ phase and/or a $CuMg_2$ phase.

In a cross section of the copper member and the graphene-containing carbonaceous member along the laminating direction, the ratio B/A is preferably 0.3 or less, more preferably 0.25 or less, and most preferably 0.15 or less, where A ($\mu m^2$) is the area of a region in the Mg solid solution layer 42 within a distance of 50 $\mu m$ from a boundary surface 40a between the Mg solid solution layer 42 and the active metal carbide layer 41 toward the copper member, and B ($\mu m^2$) is the area of the Cu-Mg intermetallic compound phase.

The Mg solid solution layer 42 may not contain the Cu-Mg intermetallic compound phase, in other words, the ratio B/A may be 0.

The active metal carbide layer 41 is formed by reacting the active metal contained in a joining material interposed between the copper plate 21 and the carbon plate 25 during joining with carbon contained in the carbon plate 25.

Examples of the active metal constituting the active metal carbide layer 41 may include one or more kinds selected from Ti, Zr, Hf, and Nb. In the present embodiment, it is assumed that the active metal is Ti and the active metal carbide layer 41 is composed of titanium carbide (Ti-C).

Here, if the thickness $t_1$ of the active metal carbide layer 41 is less than 0.05 $\mu m$, the reaction between the active metal and carbon may not become sufficient, and a joining strength between the copper plate 21 and the carbon plate 25 via the active metal carbide layer 41 may not become sufficient. On the other hand, if the thickness $t_1$ of the active metal carbide layer 41 exceeds 1.5 $\mu m$, cracks may occur in the active metal carbide layer 41 during loading of the thermal cycles.

Therefore, in the present embodiment, the thickness $t_1$ of the active metal carbide layer 41 is preferably set to be within a range of 0.05 $\mu m$ or more and 1.5 $\mu m$ or less.

A lower limit of the thickness $t_1$ of the active metal carbide layer 41 is preferably 0.1 $\mu m$ or more, and more preferably 0.25 $\mu m$ or more. On the other hand, an upper limit of the thickness $t_1$ of the active metal carbide layer 41 is preferably 1.2 $\mu m$ or less, and more preferably 1.0 $\mu m$ or less.

The ceramic plate 26 is joined to the copper plate 21 via the compound layer 43. The compound layer 43 is a layer formed by reacting one or more kinds of active metals selected from Ti, Zr, Nb, and Hf, or Mg with constituent elements of the ceramic plate 26 as a joining material. A ceramic plate containing oxides such as $Al_2O_3$ and Zr-added $Al_2O_3$, nitrides such as AlN and $Si_3N_4$, and SiAlON are used as the ceramic plate 26.

When the ceramic plate 26 contains an oxide as a main component, Mg is preferably used as a joining material, and in this case, the main element constituting the compound layer 43 is MgO. In addition, when the ceramic plate 26 contains a nitride as a main component, Ti is preferably used as a joining material, and in this case, the main element constituting the compound layer 43 is TiN.

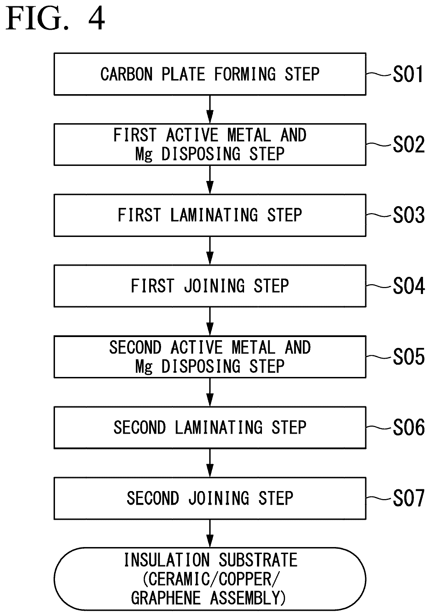

Next, a method for manufacturing a ceramic/copper/graphene assembly (insulation substrate 20) according to the present embodiment will be described with reference to a flowchart shown in Fig. 4.

(Carbon Plate Forming Step S01)

First, the flat graphite particles and the graphene aggregate described above are weighed so as to obtain a predetermined blending ratio, and are mixed by an existing mixing device such as a ball mill.

The obtained mixture is filled in a mold having a predetermined shape and pressurized, thereby obtaining a molded body. Heating may be performed during pressurization.

The obtained molded body is then cut out to obtain a carbon plate 25.

A pressure during molding is preferably set to be within a range of 20 MPa or more and 1,000 MPa or less, and more preferably set to be within a range of 100 MPa or more and 300 MPa or less.

In addition, a temperature during molding is preferably set to be within a range of 50°C or higher and 300°C or lower.

Moreover, a pressurizing time is preferably set to be within a range of 0.5 minutes or longer and 10 minutes or shorter.

(First Active Metal And Mg Disposing Step S02)

Next, the copper plate 21 formed of copper or a copper alloy is prepared, and one or more kinds of active metals selected from Ti, Zr, Nb, and Hf and Mg are disposed between the copper plate 21 and the carbon plate 25 as a joining material by allowing a joining surface of the copper plate 21 and the joining surface of the carbon plate 25 obtained in the previous step to face each other. When the copper plate 21 is changed to a plate formed of another material, Cu is further disposed as a joining material.

The active metal and Mg can be disposed by sputtering, (co-) evaporation, foil material, or application of paste (active metal and hydride of Mg are also available).

As the joining material, the amount of the active metal disposed between the copper plate 21 and the carbon plate 25 is set to 0.4 $\mu$mol/cm$^2$ or more, and the amount of Mg is set to 14 $\mu$mol/cm$^2$ or more. Preferably, the amount of the active metal is set to be within a range of 0.4 $\mu$mol/cm$^2$ or more and 47.0 $\mu$mol/cm$^2$ or less, the amount of Cu is set to be within a range of 4 $\mu$mol/cm$^2$ or more and 350 $\mu$mol/cm$^2$ or less, and the amount of Mg is set to be within a range of 14 $\mu$mol/cm$^2$ or more and 180 $\mu$mol/cm$^2$ or less.

(First Laminating Step S03)

Next, the copper plate 21 is laminated (bonded) to each of both main surfaces of the carbon plate 25 described above via a joining material.

(First Joining Step S04)

Next, the carbon plate 25 and the copper plate 21 laminated via the joining material are pressurized in the laminating direction, heated, and then cooled to join the carbon plate 25, the copper plate 21, and the ceramic plate 26.

In this case, a heating temperature is preferably set to be within a range of 700°C or higher and 950°C or lower. In addition, a holding time at the heating temperature is preferably set to be within a range of 10 minutes or longer and 180 minutes or shorter. Moreover, a pressurizing pressure is preferably set to be within a range of 0.049 MPa or more and 1.96 MPa or less. In addition, an atmosphere during joining is preferably a non-oxidative atmosphere.

Through the first joining step S04, the active metal contained in the joining material (Ti in the present embodiment) reacts with carbon contained in the carbon plate 25 at the joining interface between the carbon plate 25 and the copper plate 21, thereby forming an active metal carbide layer 41 on the joining surface of the carbon plate 25.

Cu, Mg, and a part of the active metal contained in the joining material are absorbed into the copper plate 21, and Cu and Mg contained in the joining material react with each other, thereby forming a Mg solid solution layer 42 having Mg dissolved in a matrix phase of Cu between the copper plate 21 and the active metal carbide layer 41. In the Mg solid solution layer 42, a Cu-Mg intermetallic compound phase formed of an intermetallic compound containing Cu and Mg may be present, or a second intermetallic compound phase formed of an intermetallic compound containing Cu and an active metal may be present.

(Second Active Metal And Mg Disposing Step S05)

Next, the ceramic plate 26 is prepared, and a material formed of at least one of one or more kinds of active metals selected from Ti, Zr, Nb, and Hf, and Mg is disposed between the ceramic plate 26 and the copper plate 25 by allowing the joining surface of the ceramic plate 26 and the joining surface of the copper plate 25 to face each other.

The active metal and Mg can be disposed by sputtering, (co-) evaporation, foil material, or application of paste (active metal and hydride of Mg are also available).

When one or more kinds of active metals selected from Ti, Zr, Nb, and Hf are disposed between the copper plate 21 and the ceramic plate 25 as a joining material, the amount of the active metal disposed is preferably set to be within a range of 0.4 $\mu$mol/cm$^2$ or more and 47.0 $\mu$mol/cm$^2$ or less. In addition, when Mg is disposed between the copper plate 21 and the ceramic plate 25 as a joining material, the amount of Mg disposed is preferably set to be within a range of 14 $\mu$mol/cm$^2$ or more and 180 $\mu$mol/cm$^2$ or less.

(Second Laminating Step S06)

Next, the ceramic plate 26 is laminated on each of two copper plates 21 laminated on the carbon plate 25 via a joining material. In this case, the joining surface of the copper plate 21 is the main surface opposite to the carbon plate 25.

(Second Joining Step S07)

Next, the copper plate 21 and the ceramic plate 26 laminated via the joining material are pressurized in the laminating direction, heated, and then cooled to join the copper plate 21 and the ceramic plate 26.

In this case, a heating temperature is preferably set to be within a range of 700°C or higher and 950°C or lower. In addition, a holding time at the heating temperature is preferably set to be within a range of 10 minutes or longer and 90 minutes or shorter. Moreover, a pressurizing pressure is preferably set to be within a range of 0.049 MPa or more and 1.96 MPa or less. In addition, an atmosphere during joining is preferably a non-oxidative atmosphere.

Through the second joining step S07, oxygen or nitrogen constituting the ceramic plate 26 reacts with an element of the joining material even at the joining interface between the copper plate 21 and the ceramic plate 26, thereby forming an oxide layer or a nitride layer.

When the ceramic plate 26 contains oxides such as $Al_2O_3$ or Zr-added $Al_2O_3$, and the joining material of the copper plate 21 and the ceramic plate 26 is Mg, Mg reacts with oxygen contained in the ceramic plate 26 through the joining step S04, thereby forming a MgO layer (compound layer 43) at the joining interface between the copper plate 21 and the ceramic plate 26.

When the ceramic plate 26 contains nitrides such as AlN or $Si_3N_4$, and the joining material of the copper plate 21 and the ceramic plate 26 is Ti, Ti reacts with nitrogen contained in the ceramic plate 26 through the joining step S04, thereby forming a TiN layer (compound layer 43) at the joining interface between the copper plate 21 and the ceramic plate 26.

When the ceramic plate 26 contains SiAlON, and the joining material of the copper plate 21 and the ceramic plate 26 is Ti, Ti reacts with nitrogen contained in the ceramic plate 26 through the joining step S04, thereby forming a TiN layer (compound layer 43) at the joining interface between the copper plate 21 and the ceramic plate 26.

Through the above steps, a ceramic/copper/graphene assembly (insulation substrate 20) according to the present embodiment is manufactured.

In the above-described embodiment, the copper plate 21 and the ceramic plate 26 are joined after joining the carbon plate 25 and the copper plate 21, but the carbon plate 25, the copper plate 21, and the ceramic plate 26 may be joined at the same time.

Specifically, first, one or more kinds of active metals selected from Ti, Zr, Nb, and Hf and Mg are disposed on one surface of the carbon plate 25 as a joining material, and the copper plate 21 is laminated on the disposed active metal and Mg. Moreover, one or more kinds of active metals selected from Ti, Zr, Nb, and Hf and Mg are disposed on the copper plate 21 as a joining material, and the ceramic plate 26 is laminated on the disposed active metal and Mg.

When the copper plate 21 and the ceramic plate 26 are laminated on the other surface of the carbon plate 25, the carbon plate 25, the copper plate 21, and the ceramic plate 26 are laminated in the same manner.

The active metal and Mg can be disposed by sputtering, (co-) evaporation, foil material, or application of paste (active metal and hydride of Mg are also available).

Next, the carbon plate 25, the copper plate 21, and the ceramic plate 26 are pressurized in the laminating direction, heated, and then cooled to join the carbon plate 25, the copper plate 21, and the ceramic plate 26.

In this case, a heating temperature is preferably set to be within a range of 700°C or higher and 950°C or lower. In addition, a holding time at the heating temperature is preferably set to be within a range of 10 minutes or longer and 180 minutes or shorter. Moreover, a pressurizing pressure is preferably set to be within a range of 0.049 MPa or more and 1.96 MPa or less. In addition, an atmosphere during joining is preferably a non-oxidative atmosphere.

As described above, according to the ceramic/copper/graphene assembly (insulation substrate 20) of the present embodiment, at the joining interface between the copper member (copper plate 21) and the graphene-containing carbonaceous member (carbon plate 25), the active metal carbide layer 41 is formed on a joining surface of the graphene-containing carbonaceous member, and the Mg solid solution layer 42 having Mg dissolved in the matrix phase of Cu is formed on a joining surface side of the copper member. As a result, since Mg in the Mg solid solution layer 42 sufficiently reacts with the active metal in the active metal carbide layer 41, and the copper member is firmly joined to a graphene-containing carbonaceous material via the active metal carbide layer 41, it is possible to prevent cracks and peeling from occurring at the joining interface during loading of the thermal cycles. Moreover, the ceramic/copper/graphene assembly according to the present embodiment contains copper as a constituent material thereof, and thus has a function of efficiently dissipating heat as a heat spreader in a transition period.

Further, in the ceramic/copper/graphene assembly according to the present embodiment, the copper member having conductivity is covered with the ceramic member, such that it is possible to prevent a current from flowing into the joined part through the copper member, and to maintain joining between the copper member and the graphene-containing carbonaceous member, when the assembly comes into contact with a predetermined device.

Therefore, the ceramic/copper/graphene assembly according to the present embodiment can maintain stable heat dissipation characteristics and can realize high reliability while preventing occurrence of peeling at the joining interface accompanied by the thermal cycles.

Further, in the ceramic/copper/graphene assembly according to the present embodiment, preferably, a Cu-Mg intermetallic compound phase formed of an intermetallic compound containing Cu and Mg is present in the Mg solid solution layer. In this case, the Cu-Mg intermetallic compound phase is distributed on a joining surface side with the active metal carbide layer, which is greatly involved in the joining, such that it is possible to enhance the strength of the joining with the active metal carbide layer.

Further, in the ceramic/copper/graphene assembly according to the present embodiment, preferably, a second intermetallic compound phase formed of an intermetallic compound containing Cu and an active metal is present in the Mg solid solution layer. In this case, the second intermetallic compound phase is distributed on a joining surface side with the active metal carbide layer, which is greatly involved in the joining, such that it is possible to enhance the strength of the joining with the active metal carbide layer.

In addition, in the ceramic/copper/graphene assembly according to the present embodiment, the ceramic member is composed of oxygen-containing ceramic, and a magnesium oxide layer may be formed on a ceramic member side at the joining interface between the ceramic member and the copper member. In this case, it is possible to strengthen the joining between the oxygen-containing ceramic member and the copper member due to the formation of the magnesium oxide layer, and it is possible to prevent cracks and peeling from occurring at the joining interface during loading of the thermal cycles.

In addition, in the ceramic/copper/graphene assembly according to the present embodiment, the ceramic member is composed of nitrogen-containing ceramic, and an active metal nitride layer containing a nitride of one or more kinds of active metals selected from Ti, Zr, Nb, and Hf may be formed on the ceramic member side at the joining interface between the ceramic member and the copper member. In this case, it is possible to strengthen the joining between the nitride-containing ceramic member and the copper member due to the formation of the active metal nitride layer containing a nitride of one or more kinds of active metals selected from Ti, Zr, Nb, and Hf, and it is possible to prevent cracks and peeling from occurring at the joining interface during loading of the thermal cycles.

Moreover, in the ceramic/copper/graphene assembly according to the present embodiment, the graphene-containing carbonaceous member contains a graphene aggregate formed by deposition of a single layer or multiple layers of graphene, and flat graphite particles, and preferably has a structure in which the flat graphite particles are laminated with the graphene aggregate as a binder so that basal surfaces of the flat graphite particles overlap with one another, and the basal surfaces of the flat graphite particles are oriented in one direction. In this case, thermal conduction properties of the graphene-containing carbonaceous member can be further improved.

The embodiments of the present invention have been described as above, but the present invention is not limited thereto, and can be appropriately modified without departing from the technical ideas of the invention.

For example, in the present embodiment, the configuration in which a semiconductor element (power semiconductor element) is mounted on the circuit layer of the insulating circuit substrate to constitute a power module has been described, but the present invention is not limited thereto. For example, an LED element may be mounted on the insulating circuit substrate to constitute an LED module, or a thermoelectric element may be mounted on the circuit layer of the insulating circuit substrate to constitute a thermoelectric module.

Further, it has been described in the present embodiment that the insulation substrate 20 according to the present embodiment is applied as an insulating layer of the insulating circuit substrate 10 as shown in Fig. 1. However, the present invention is not limited thereto, and there is no particular limitation on a method for using a ceramic/copper/graphene assembly according to the present invention.

[Examples]

Confirmation experiments (Inventive Examples 1 to 8 and 11 to 19, and Comparative Examples 1 to 3) performed to confirm the effectiveness of the present invention will be described.

As disclosed in the present embodiment, flat graphite particles and a graphene aggregate were blended at a predetermined blending ratio and mixed. The mixture was heated under pressure and molded to obtain a molded body having a structure in which the flat graphite particles were laminated with the graphene aggregate as a binder so that the basal surfaces of the flat graphite particles overlapped with one another. The obtained molded body was cut out to obtain a carbon plate (40 mm × 40 mm × thickness 1.0 mm).

Mg and an active metal were disposed on one surface of the carbon plate at the amount of Mg and the amount of the active metal shown in Tables 1 and 2, a copper plate (37 mm × 37 mm × thickness 0.3 mm) was laminated on the disposed Mg and active metal, and furthermore, Mg and an active metal were disposed on the copper plate at the amount of Mg and the amount of the active metal shown in Tables 1 and 2, and a ceramic plate (made of silicon nitride, 37 mm × 37 mm × thickness 0.3 mm) was laminated on the disposed Mg and active metal, thereby joining the carbon plate, the copper plate, and the ceramic plate under conditions shown in Tables 1 and 2.

The amount of Mg and the amount of the active metal disposed on one surface of the carbon plate were the same as the amount of Mg and the amount of the active metal disposed on the copper plate.

The Mg and active metal were disposed using co-evaporation.

Here, a joining interface between the carbon plate and the copper plate was observed, and confirmation was made whether or not an active metal carbide layer is present, whether or not a Cu-Mg intermetallic compound phase is present, whether or not an active metal compound phase is present, and whether or not a Mg solid solution layer is present.

(Whether or Not Active Metal Carbide Layer Is Present)

The joining interface between the copper plate and the carbon plate in a cross section of the obtained assembly in the laminating direction was observed under conditions of a magnification from 20,000 times to 120,000 times and an accelerating voltage of 200 kV using a scanning transmission electron microscope (Titan ChemiSTEM (with EDS detector) manufactured by Thermo Fisher Scientific). Mapping was performed using energy dispersive X-ray analysis (NSS7 manufactured by Thermo Fisher Scientific), an electron diffraction pattern was obtained by irradiating a region where the active metal and C overlap with each other with an electron beam narrowed to about 1 nm (nano beam diffraction (NBD) method), and when the electron diffraction pattern was intermetallic compounds of the active metal and C, the active metal carbide layer was defined as "present".

(Whether or Not Cu-Mg Intermetallic Compound Phase Is Present)

The joining interface between the copper plate and the carbon plate in the cross section of the obtained assembly in the laminating direction was observed under conditions of a magnification of 2,000 times and an accelerating voltage of 15 kV using an electron beam microanalyzer (JXA-8539F manufactured by JEOL Ltd.), and elemental mapping of Mg in a region including the joining interface (400 $\mu$m $\times$ 600 $\mu$m, hereinafter, referred to as an observation region) was obtained. Confirmation was made whether or not the Cu-Mg intermetallic compound phase is present in a region, as a Cu-Mg intermetallic compound phase, satisfying a Cu concentration of 5 atom% or more and a Mg concentration of 30 atom% or more and 70 atom% or less from a 5-point average of quantitative analysis in the region confirmed by the presence of Mg. The concentration here is the concentration when the total amount of Cu and Mg is 100 atom%.

In addition, in the assembly of Inventive Examples 11 to 19, a ratio B/A was measured when the area of a region in the observation region within a distance of 50 $\mu$m from a boundary between an active metal carbonized layer and the Mg solid solution layer toward the copper member was defined as A, and the area of the Cu-Mg intermetallic compound phase of a region in the observation region within a distance of 50 $\mu$m from a boundary between the active metal carbonized layer and the Mg solid solution layer toward the copper member was defined as B.

(Whether or Not Active Metal Compound Phase Is Present)

A joining interface between the copper plate and the ceramic substrate was observed under conditions of a magnification of 2,000 times and an accelerating voltage of 15 kV using an electron beam microanalyzer (JXA-8539F manufactured by JEOL Ltd.), and elemental mapping of the active metal in a region including the joining interface (400 $\mu$m $\times$ 600 $\mu$m) was obtained. Confirmation was made whether or not the active metal compound phase is present in a region, as a Cu-active intermetallic compound phase, satisfying a Cu concentration of 5 atom% or more and an active metal concentration of 16 atom% or more and 70 atom% or less from a 5-point average of quantitative analysis in the region confirmed by the presence of the active metal, thereby showing whether or not the second intermetallic compound phase is present. The concentration here is the concentration when the total amount of Cu and the active metal is 100 atom%.

(Whether or Not Mg Solid Solution Phase Is Present)

A region including the joining interface between the copper plate and the ceramic substrate (400 $\mu$m $\times$ 600 $\mu$m) was observed under conditions of a magnification of 2,000 times and an accelerating voltage of 15 kV using an electron beam microanalyzer (JXA-8539F manufactured by JEOL Ltd.). Quantitative analysis was performed at intervals of 10 $\mu$m from a surface of the ceramic substrate toward the copper plate in a range of 10 points or more and 20 points or less according to the thickness of the copper plate, and confirmation was made whether or not the Mg solid solution phase is present in a region, as a Mg solid solution phase, having the Mg concentration of 0.01 atom% or more and 6.9 atom% or less.

2,000 heat shock cycles of -40°C $\times$ 5 minutes $\leftrightarrow$ 150°C $\times$ 5 minutes were then applied to the obtained assembly in Inventive Examples 1 to 8 and Comparative Examples 1 to 3.

In addition, a heating test in which heating at 400°C for 30 minutes and cooling to room temperature (25°C) were repeated 10 times in a vacuum atmosphere was performed on the obtained assembly in Inventive Examples 11 to 19.

Thereafter, an initial joining area and a non-joining area between the carbon plate and the copper plate were measured for these assemblies using an ultrasonic flaw detector (FineSAT200 manufactured by Hitachi Power Solutions Co., Ltd.) to calculate the joining ratio of the interface between the carbon plate and the copper plate from the following equation.

$$\text{(Joining Ratio)} = [\{\text{(Initial Joining Area)}-\text{(Non-Joining Area)}\}/\text{(Initial Joining Area)}] \times 100$$

The initial joining area here means the area of a part to be joined. Further, the non-joining area means the area of a part that is not actually joined, that is, the area of a part that is peeled off, among parts to be joined. Since the peeling was indicated by a white part in the joined part in an image obtained by binarizing an ultrasonic flaw detection image, the area of the white part was defined as a non-joining area (peeling area).

[Table 1]

| | Mg And Active Metal Disposing Step | | | Joining Step | | | Whether or Not Active Metal Carbide Layer Is Present | Whether or Not Mg Solid Solution Layer Is present | Whether or Not Cu-Mg Intermetallic Compound Phase Is Present | Whether or Not Second Intermetallic Compound Phase Is Present | Joining Ratio (%) | |
|---|---|---|---|---|---|---|---|---|---|---|---|---|
| | Amount of Mg μmol/cm² | Active Metal | | Load MPa | Holding Temperature °C | Holding Time min | | | | | Initial | After Loading Thermal Cycles |
| | | Element | μmol/cm² | | | | | | | | | |
| Inventive Example 1 | 42.9 | Ti | 0.4 | 0.049 | 700 | 30 | Presence | Presence | Presence | Presence | 98.8 | 93.6 |
| In venti ve Example 2 | 178.8 | Ti | 10.1 | 1.96 | 950 | 30 | Presence | Presence | Presence | Absence | 99.3 | 92.5 |
| Inventive Example 3 | 42.9 | Zr | 1.8 | 0.392 | 950 | 90 | Presence | Presence | Absence | Absence | 98.1 | 91.6 |
| Inventive Example 4 | 28.6 | Zr | 1.8 | 0.196 | 700 | 180 | Presence | Presence | Absence | Absence | 97.6 | 92.2 |
| Inventive Example 5 | 14.3 | Ti | 10.1 | 0.392 | 900 | 120 | Presence | Presence | Absence | Presence | 99.2 | 96.9 |
| Inventi ve Example 6 | 42.9 | Zr | 14.8 | 0.392 | 900 | 60 | Presence | Presence | Absence | Presence | 97.3 | 96.8 |
| Inventive Example 7 | 128.7 | Nb | 20.7 | 1.176 | 950 | 90 | Presence | Presence | Absence | Presence | 97.8 | 96.6 |
| Inventive Example 8 | 85.8 | Hf | 47.0 | 1.96 | 800 | 90 | Presence | Presence | Presence | Presence | 98.3 | 95.4 |
| Comparative Example 1 | 7.2 | Ti | 10.1 | 0.392 | 900 | 120 | Absence | Absence | Absence | Presence | 47.5 | 1.8 |
| Comparati ve Example 2 | 28.6 | Ti | 0.2 | 0.392 | 900 | 120 | Absence | Presence | Presence | Absence | 52.1 | 0.0 |
| Comparative Example 3 | 7.2 | Zr | 0.1 | 0.392 | 900 | 60 | Absence | Absence | Absence | Absence | 39.2 | 0.0 |

EP 4 063 340 A1

[Table 2]

| | Mg And Active Metal Disposing Step | | | Joining Step | | | Whether or Not Active Metal Carbide Layer Is Present | Whether or Not Mg Solid Solution Layer Is present | Cu-Mg Intermetallic Compound Phase | | Whether or Not Second Intermetallic Compound Phase Is Present | Joining Ratio (%) | |
|---|---|---|---|---|---|---|---|---|---|---|---|---|---|
| | Amount of Mg $\mu mol/cm^2$ | Active Metal | | Load MPa | Holding Temperature °C | Holding Time min | | | Prescence or Absence | Ratio B/A | | Initial | After Heating Test |
| | | Element | $\mu mol/cm^2$ | | | | | | | | | | |
| Inventive Example 11 | 178.8 | Ti | 10.1 | 1.96 | 700 | 30 | Presence | Presence | Presence | 0.299 | Absence | 98.8 | 89.1 |
| Inventive Example 12 | 178.8 | Ti | 10.1 | 1.96 | 950 | 30 | Presence | Presence | Presence | 0.038 | Absence | 97.9 | 95.5 |
| Inventive Example 13 | 178.8 | Ti | 10.1 | 1.96 | 950 | 90 | Presence | Presence | Absence | 0.000 | Absence | 98.1 | 96.0 |
| Inventive Example 14 | 42.9 | Zr | 14.8 | 0.392 | 700 | 10 | Presence | Presence | Presence | 0.206 | Presence | 98.4 | 91.8 |
| Inventive Example 15 | 42.9 | Zr | 14.8 | 0.392 | 720 | 60 | Presence | Presence | Presence | 0.147 | Presence | 97.1 | 94.7 |
| Inventive Example 16 | 42.9 | Zr | 14.8 | 0.392 | 900 | 60 | Presence | Presence | Absence | 0.000 | Presence | 97.3 | 95.9 |
| Inventive Example 17 | 85.8 | Hf | 47.0 | 1.96 | 700 | 90 | Presence | Presence | Presence | 0.246 | Presence | 97.3 | 91.1 |
| Inventive Example 18 | 85.8 | Hf | 47.0 | 1.96 | 720 | 90 | Presence | Presence | Presence | 0.182 | Presence | 97.5 | 92.5 |
| Inventive Example 19 | 85.8 | Hf | 47.0 | 1.96 | 800 | 90 | Presence | Presence | Presence | 0.074 | Presence | 98.7 | 95.2 |

14

In Comparative Example 1, since the amount of Mg was small, the amount of liquid phase generated at the interface was small, and the active metal carbide layer was not sufficiently formed. In Comparative Example 2, since the amount of the active metal was small, the active metal carbide layer was not sufficiently formed. In Comparative Example 3, since the amount of Mg was small, the amount of liquid phase generated at the interface was small, and furthermore, since the amount of the active metal was small, the active metal carbide layer was not sufficiently formed. Therefore, the joining ratio between the copper plate and the carbon plate shows a low value of less than 55% at the initial stage, and is about 0 to 2% after loading the thermal cycles, such that it is found that the joining is almost completely eliminated.

On the other hand, since the ceramic/copper/graphene assembly in Inventive Examples 1 to 8 and 11 to 19 includes the active metal carbide layer and the Mg solid solution layer at the joined part, the joining ratio between the copper plate and the carbon plate shows a high value over 95%, such that it is found that the joining ratio does not fall below 90% even if the loading of the thermal cycles or the heating test is performed in the same manner as in Comparative Examples 1 to 3. It is found from these results that the ceramic/copper/graphene assembly in Inventive Examples 1 to 8 and 11 to 19 has sufficient strength to prevent peeling during loading of a cooling cycle and realizes high reliability.

[Reference Signs List]

20: Insulation substrate (ceramic/copper/graphene assembly)
21: Copper plate (copper member)
25: Carbon plate (graphene-containing carbonaceous member)
26: Ceramic plate (ceramic member)
40: Joining interface
40a: Boundary surface
41: Active metal carbide layer
42: Mg solid solution layer
43: Compound layer

**Claims**

1.   A ceramic/copper/graphene assembly comprising:

a structure in which a ceramic member, a copper member formed of copper or a copper alloy, and a graphene-containing carbonaceous member containing a graphene aggregate are joined, wherein
at a joining interface between the copper member and the graphene-containing carbonaceous member, an active metal carbide layer containing a carbide of one or more kinds of active metals selected from Ti, Zr, Nb, and Hf is formed on a side of the graphene-containing carbonaceous member, and
a Mg solid solution layer having Mg dissolved in a matrix phase of Cu is formed between the active metal carbide layer and the copper member.

2.   The ceramic/copper/graphene assembly according to Claim 1, wherein,
a Cu-Mg intermetallic compound phase formed of an intermetallic compound containing Cu and Mg is present in the Mg solid solution layer.

3.   The ceramic/copper/graphene assembly according to Claim 2, wherein,
a ratio B/A is 0.3 or less, where A is an area of a region in the Mg solid solution layer within a distance of 50 $\mu$m from a boundary between the active metal carbonized layer and the Mg solid solution layer toward the copper member, and B is an area of the Cu-Mg intermetallic compound phase.

4.   The ceramic/copper/graphene assembly according to any one of Claims 1 to 3, wherein.
a second intermetallic compound phase formed of an intermetallic compound containing Cu and the active metal is present in the Mg solid solution layer.

5.   The ceramic/copper/graphene assembly according to any one of Claims 1 to 4, wherein,

the ceramic member is composed of oxygen-containing ceramic, and

a magnesium oxide layer is formed on a side of the ceramic member at a joining interface between the ceramic member and the copper member.

6. The ceramic/copper/graphene assembly according to any one of Claims 1 to 4, wherein,

the ceramic member is composed of nitrogen-containing ceramic, and
an active metal nitride layer containing a nitride of one or more kinds of active metals selected from Ti, Zr, Nb, and Hf is formed on a side of the ceramic member at a joining interface between the ceramic member and the copper member.

7. The ceramic/copper/graphene assembly according to any one of Claims 1 to 6, wherein,

the graphene-containing carbonaceous member contains flat graphite particles and the graphene aggregate formed by deposition of a single layer or multiple layers of graphene,
the flat graphite particles has a structure in which the flat graphite particles are laminated with the graphene aggregate as a binder so that basal surfaces of the flat graphite particles overlap with one another, and the basal surfaces of the flat graphite particles are oriented in one direction.

8. A method for manufacturing the ceramic/copper/graphene assembly according to any one of Claims 1 to 7, the method comprising:

a copper/graphene joining step of joining the copper membe and the graphene-containing carbonaceous member; and
a copper/ceramic joining step of joining the copper member and the ceramic member, wherein,
the copper/graphene joining step includes,

an active metal and Mg disposing step of disposing one or more kinds of active metals selected from Ti, Zr, Nb, and Hf and Mg between the copper member and the graphene-containing carbonaceous member,
a laminating step of laminating the copper member and the graphene-containing carbonaceous member via the active metal and Mg, and
a joining step of joining the copper member and the graphene-containing carbonaceous member by laminating the copper member and the graphene-containing carbonaceous member via the active metal and Mg and performing a heat-treat in a vacuum atmosphere while pressurizing the copper member and the graphene-containing carbonaceous member in a laminating direction, and

in the active metal and Mg disposing step, an amount of the active metal is set to 0.4 $\mu$mol/cm$^2$ or more, and an amount of Mg is set to 14 $\mu$mol/cm$^2$ or more.

9. The method for manufacturing a ceramic/copper/graphene assembly according to Claim 8, wherein,

a pressurizing load in the joining step is set to be within a range of 0.049 MPa or more and 1.96 MPa or less, and
a heating temperature in the joining step is set to be within a range of 700°C or higher and 950°C or lower.

10. The method for manufacturing a ceramic/copper/graphene assembly according to Claim 8 or 9, wherein, in the copper/ceramic joining step, one or more kinds of active metals selected from Ti, Zr, Nb, and Hf and Mg are disposed between the copper member and the ceramic member, and are heat-treated and joined in a vacuum atmosphere while pressurizing in the laminating direction, together with the copper member and the graphene-containing carbonaceous member which are laminated via the active metal and Mg.

11. The method for manufacturing a ceramic/copper/graphene assembly according to Claim 8 or 9, wherein, in the copper/ceramic joining step, Mg is disposed between the copper member and the ceramic member, and is heat-treated and joined in a vacuum atmosphere while pressurizing in the laminating direction, together with the copper member and the graphene-containing carbonaceous member which are laminated via Mg.

12. A ceramic/copper/graphene joining structure comprising:

a structure in which a ceramic member, a copper member formed of copper or a copper alloy, and a graphene-containing carbonaceous member containing a graphene aggregate are joined, wherein,

at a joining interface between the copper member and the graphene-containing carbonaceous member, an active metal carbide layer containing a carbide of one or more kinds of active metals selected from Ti, Zr, Nb, and Hf is formed on a side of the graphene-containing carbonaceous member, and
a Mg solid solution layer having Mg dissolved in a matrix phase of Cu is formed between the active metal carbide layer and the copper member.

# FIG. 1

# FIG. 2

# FIG. 3

# FIG. 4

```
┌─────────────────────────────┐
│   CARBON PLATE FORMING STEP  │ ──── S01
└─────────────────────────────┘
              │
              ▼
┌─────────────────────────────┐
│     FIRST ACTIVE METAL AND   │ ──── S02
│      Mg DISPOSING STEP       │
└─────────────────────────────┘
              │
              ▼
┌─────────────────────────────┐
│     FIRST LAMINATING STEP    │ ──── S03
└─────────────────────────────┘
              │
              ▼
┌─────────────────────────────┐
│      FIRST JOINING STEP      │ ──── S04
└─────────────────────────────┘
              │
              ▼
┌─────────────────────────────┐
│    SECOND ACTIVE METAL AND   │ ──── S05
│      Mg DISPOSING STEP       │
└─────────────────────────────┘
              │
              ▼
┌─────────────────────────────┐
│    SECOND LAMINATING STEP    │ ──── S06
└─────────────────────────────┘
              │
              ▼
┌─────────────────────────────┐
│      SECOND JOINING STEP     │ ──── S07
└─────────────────────────────┘
              │
              ▼
   ╭─────────────────────────────╮
   │    INSULATION SUBSTRATE      │
   │      (CERAMIC/COPPER/        │
   │     GRAPHENE ASSEMBLY)       │
   ╰─────────────────────────────╯
```

## INTERNATIONAL SEARCH REPORT

| International application No. |
| --- |
| PCT/JP2020/043413 |

**A. CLASSIFICATION OF SUBJECT MATTER**
C04B 37/02(2006.01)i; H05K 7/20(2006.01)i
FI: C04B37/02 Z; H05K7/20 D; H05K7/20 F
According to International Patent Classification (IPC) or to both national classification and IPC

**B. FIELDS SEARCHED**

Minimum documentation searched (classification system followed by classification symbols)
C04B37/02; H05K7/20

| Documentation searched other than minimum documentation to the extent that such documents are included in the fields searched | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2019-127432 A (MITSUBISHI MATERIALS CORP.) 01 August 2019 (2019-08-01) claims 1-14 | 1-12 |
| A | JP 2018-140929 A (MITSUBISHI MATERIALS CORP.) 13 September 2018 (2018-09-13) claims 1-14 | 1-12 |
| A | JP 2019-96858 A (FUJITSU KASEI KK) 20 June 2019 (2019-06-20) claims 1, 11 | 1-12 |
| A | CN 108715992 A (WUHAN UNIVERSITY) 30 October 2018 (2018-10-30) claim 1 | 1-12 |
| A | JP 2005-305526 A (HONDA MOTOR CO., LTD.) 04 November 2005 (2005-11-04) claim 1 | 1-12 |
| P, A | JP 2020-53613 A (MITSUBISHI MATERIALS CORP.) 02 April 2020 (2020-04-02) claims 1-5 | 1-12 |
| P, A | WO 2020/091008 A1 (MITSUBISHI MATERIALS CORP.) 07 May 2020 (2020-05-07) claims 1-5 | 1-12 |

☐ Further documents are listed in the continuation of Box C. ☒ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 13 January 2021 (13.01.2021) | 26 January 2021 (26.01.2021) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

Form PCT/ISA/210 (patent family annex) (January 2015)

| International application No. |
|---|
| PCT/JP2020/043413 |

| Patent Documents referred in the Report | Publication Date | Patent Family | Publication Date |
|---|---|---|---|
| JP 2019-127432 A | 01 Aug. 2019 | WO 2019/146464 A1 claims 1-14 | |
| JP 2018-140929 A | 13 Sep. 2018 | US 2020/0006213 A1 1-20 WO 2018/159590 A1 CN 110382445 A | |
| JP 2019-96858 A | 20 Jun. 2019 | WO 2019/098377 A1 claims 1, 11 | |
| CN 108715992 A | 30 Oct. 2018 | (Family: none) | |
| JP 2005-305526 A | 04 Nov. 2005 | (Family: none) | |
| JP 2020-53613 A | 02 Apr. 2020 | (Family: none) | |
| WO 2020/091008 A1 | 07 May 2020 | (Family: none) | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019211422 A
- JP 2020192559 A

- JP 2012238733 A